## Europäisches Patentamt

## European Patent Office

## Office européen des brevets

(19)

(11) Veröffentlichungsnummer: **0 025 477**
B1

(12) **EUROPÄISCHE PATENTSCHRIFT**

(45) Veröffentlichungstag der Patentschrift:
06.07.83

(51) Int. Cl.³: **G 01 R 25/00,** H 04 B 17/00

(21) Anmeldenummer: **80102634.5**

(22) Anmeldetag: **12.05.80**

(54) Verfahren und Anordnung zur Messung des Jitters von Taktsignalen in digitalen Übertragungssystemen.

(30) Priorität: **28.05.79 DE 2921573**

(43) Veröffentlichungstag der Anmeldung:
**25.03.81 Patentblatt 81/12**

(45) Bekanntmachung des Hinweises auf die Patenterteilung:
**06.07.83 Patentblatt 83/27**

(84) Benannte Vertragsstaaten:
**AT BE CH DE FR GB IT LI LU NL SE**

(56) Entgegenhaltungen:
**US-A-4 149 044**
**SOVIET INVENTIONS ILLUSTRATED, Section R:**
**Electrical Week B25, 1. August 1979, DERVENT**
**PUBLICATION LTD London, JO4**

(73) Patentinhaber: **SIEMENS AKTIENGESELLSCHAFT,**
**Berlin und München Witteisbacherplatz 2,**
**D-8000 München 2 (DE)**

(72) Erfinder: **Rehm, Hans, Dipl.-Ing., Wildenfelserstrasse 19,**
**D-8000 München 60 (DE)**

**0 025 477**

Verfahren und Anordnung zur Messung des Jitters von Taktsignalen
in digitalen Übertragungssystemen

Die Erfindung betrifft ein Verfahren zur Messung des Jitters von Taktsignalen in Übertragungssystemen hoher Bitrate unter Verwendung eines jitterfreien Referenzsignals sowie eine Anordnung zur Durchführens des Verfahrens.

Bei der Übertragung digitaler Signale in Übertragungssystemen mit räumlich ausgedehnten Übertragungsstrecken kommt es auf diesen Übertragungsstrecken zu zeitlichen Schwankungen der Phase des übertragenen digitalen Signals. Diese als Jitter bezeichneten Phasenschwankungen resultieren aus dem Sendejitter, den auf der Strecke durch Rauschstörungen verursachten Jitter und den durch die sogenannten Intersymbolstörungen, die auch als systematischer Jitter bezeichnet werden und die vom Bitmuster des übertragenen Signals abhängen verursachten Jitter. Die Übertragungsstrecke enthält in bestimmten räumlichen Abständen Regeneratoren für das digitale Signal, in denen aus dem empfangenen digitalen Signal ein Taktsignal abgeleitet wird und das digitale Signal mit diesem Taktsignal zeitlich regeneriert wird. Die Gewinnung des Taktsignals erfolgt dabei entweder in als Phasenregelschleifen ausgebildeten aktiven Filtern oder in passiven Filtern. Für eine Aussage über die Übertragungsqualität ist es notwendig, den Jitter des von den digitalen Signalen abgeleiteten Taktsignals festzustellen.

Aus D. Hall, A. Lancaster: »Prediction and Measurement of Jitter on Digital Line Links«, Proceedings IEEE Conference on Telecom. Systems, London 1975, S. 41—44 ist bereits ein Verfahren zur Jittermessung bekannt. Bei diesem Verfahren wird mit Hilfe eines jitterfreien Referenzsignals sowie eines Phasenvergleichers und eines Tiefpasses der Jitter gemessen. Bei Frequenzen von über 100 MHz wird diese Methode jedoch aufwendig und wenig praktikabel, da bei diesen und höheren Frequenzen die Realisierung eines präzisen, eichbaren Phasenvergleichers immer schwieriger wird. Die Aufgabe der Erfindung besteht also darin, ein Verfahren und eine Anordnung zur Jittermessung anzugeben, bei dem bzw. bei der kein üblicher Phasenvergleicher benötigt wird und das bzw. die auch bei den genannten hohen Frequenzen einsetzbar ist.

Erfindungsgemäß wird die Aufgabe dadurch gelöst, daß aus dem jitterbehafteten Taktsignal und aus dem jitterfreien Referenzsignal jeweils ein sinusförmiges Signal mit einer Frequenz entsprechend der Taktfrequenz gebildet wird, daß beide sinusförmigen Signale mit gleicher Amplitude aber mit einer solchen relativen Phasenverschiebung einander überlagert werden, daß dadurch das Taktsignal bei Abwesenheit von Jitter unterdrückt würde, und daß das vom Jitter bedingte verbleibende Restsignal bestimmt wird. Der besondere Vorteil des erfindungsgemäßen Verfahrens liegt darin, daß es sich um eine rein lineare Operation handelt, die bis auf die evtl. notwendige abschließende Verstärkung mittels passiver Bauelemente durchführbar ist. Ein weiterer Vorteil des erfindungsgemäßen Verfahrens liegt darin, daß keine komplizierte Umsetzung des betrachteten Signals ins Niederfrequenzband notwendig ist, da dies bei derartigen Frequenzen kaum fehlerfrei gelingt und außerdem sehr aufwendig ist.

Eine wegen der Schnelligkeit und der Übersichtlichkeit der Messung bevorzugte Ausführungsform des erfindungsgemäßen Verfahrens ergibt sich dadurch, daß das verbleibende Restsignal zur Bestimmung des Jittermomentanwertes einem Oszillografen und zur exakten Bestimmung des Jittereffektivwertes einem Leistungsmesser zugeführt wird.

Im Hinblick auf die leichte Erfassung der Wirkung von Ausgleichsleitungen bei hohen Bitraten ist eine Anordnung zur Durchführung der erfindungsgemäßen Verfahren zweckmäßig, bei der ein erster Eingang für das Referenzsignal und ein zweiter Eingang für das jitterbehaftete Taktsignal vorgesehen sind und die dadurch gekennzeichnet ist, daß mit dem ersten Eingang der Eingang einer ersten Reihenschaltung aus einer Einrichtung zur variablen Verzögerung, einem variablen Dämpfungsglied und einem ersten Tiefpaß verbunden ist, dessen Ausgang mit dem ersten Eingang eines Richtkopplers verbunden ist, daß mit dem zweiten Eingang eine zweite Reihenschaltung aus einem zweiten Tiefpaß und einem festen Dämpfungsglied verbunden ist dessen Ausgang mit dem zweiten Eingang des Richtkopplers verbunden ist, und daß der Ausgang des Richtkopplers über einen Verstärker an eine Meßeinrichtung angeschlossen ist.

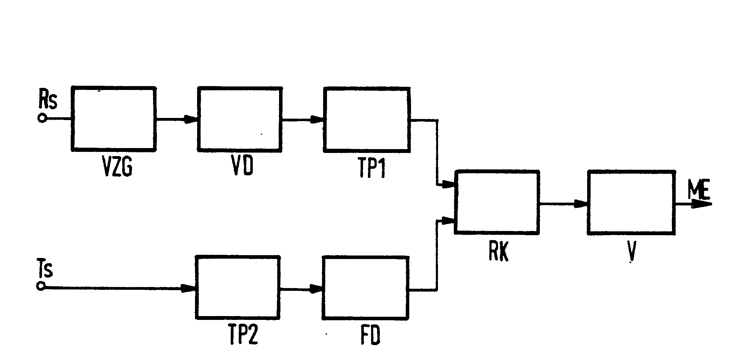

Die Erfindung soll im folgenden anhand der Zeichnung näher erläutert werden. Die dargestellte einzige Figur zeigt eine Anordnung zur Durchführung der erfindungsgemäßen Jittermeßverfahren.

In der Zeichnung ist mit Rs ein erster Eingang bezeichnet, an den das jitterfreie Referenzsignal angelegt wird. Mit diesem Eingang ist eine erste Reihenschaltung verbunden, die aus einem variablen Verzögerungsglied VZG, einem variablen Dämpfungsglied VD und einem ersten Tiefpaß TP1 besteht. Mit dem Ausgang dieser Reihenschaltung ist ein erster Eingang eines Richtkopplers Rk verbunden. In der Zeichnung ist weiterhin mit Ts ein Eingang für das jitterbehaftete Taktsignal bezeichnet, an den sich eine zweite Reihenschaltung aus einem zweiten Tiefpaß TP2 und einem festen Dämpfungsglied FD anschließt. Mit dem Ausgang dieser zweiten Reihenschaltung ist ein zweiter Eingang des Richtkopplers Rk verbunden. Mit dem Ausgang des Richtkopplers ist über einen Verstärker V eine Meßeinrichtung verbunden, die im vorliegenden Falle aus einem Samplingoszillografen und einem Leistungsmesser besteht. Zur Messung werden an die Eingänge Rs und Ts die betreffenden rechteckförmigen oder sinusförmigen Taktsignale angelegt. Durch Einstellen der Verzögerung auf

2

einen Wert entsprechend 180° Phasenverschiebung am variablen Verzögerungsglied VZG werden die beiden Taktsignale phasenmäßig miteinander kombiniert, durch Einstellen der Amplitude des jitterfreien Taktsignals am variablen Dämpfungsglied VD werden beide Signale hinsichtlich der Amplitude zur Deckung gebracht. Der erste und der zweite Tiefpaß TP1, 2 sind so ausgelegt, daß deren Grenzfrequenz so oberhalb der Taktfrequenz liegt, daß die Oberwellen der Taktfrequenz sicher unterdrückt werden. Von den beiden Tiefpässen werden eventuelle Rechteckschwingungen in Sinusschwingungen umgewandelt, wobei die dem verjitterten Taktsignal entsprechende Sinusschwingung weiterhin verjittert ist.

Die Überlagerung der beiden Schwingungen erfolgt im vorliegenden Falle in einen Richtkoppler als Entkopplungsglied, der Entkopplungsgrad zwischen dessen beiden Eingängen liegt im vorliegenden Falle bei 35 dB. Dieser vergleichsweise hohe Entkopplungsgrad bei den betrachteten Frequenzen von einigen 100 MHz ist notwendig, um eine Rückwirkung des verjitterten Taktsignals auf das jitterfreie Taktsignal und dadurch eine Verfälschung der Messung zu verhindern. Aus der Subtraktion der beiden Sinusschwingungen ergibt sich an den Stellen, an denen aufgrund des Jitters beide Schwingungen nicht zur Deckung gelangen, ein Restsignal, das vom Ausgang des Richtkopplers Rk dem Eingang eines Verstärkers V zugeführt wird. Dieser Verstärker ist im Hinblick auf den Anschluß eines Leistungsmessers zur genauen Bestimmung des Restsignals (Erhöhung der Meßgenauigkeit) notwendig, das Restsignal könnte auch vom Ausgang des Richtkopplers direkt einem Oszillografen oder einer Einrichtung zur Spektrumsanalyse zugeführt werden. Die aus dem verjitterten rechteckförmigen Taktsignal mittels des zweiten Tiefpasses TP2 erzeugte Sinusschwingung hat die Form

$$A \cdot \sin [\Omega t + \varphi(t)],$$

wobei $\varphi(t)$ den Phasenjitter beschreibt, $\Omega$ die Kreisfrequenz und A die Amplitude darstellt. Bei der Differenzbildung der jitterbehafteten und der jitterfreien Schwingung ergibt sich

$$A \cdot \sin [\Omega t + \varphi(t)] - A \sin \Omega t = 2A \sin \frac{\varphi(t)}{2} \cdot \cos \left(\Omega t - \frac{\varphi(t)}{2}\right)$$

Die Größen $A_\varphi = 2A \cdot \sin \frac{\varphi(t)}{2}$ und A können mit Hilfe eines Oszillografen bestimmt werden und man erhält für den zeitlichen Verlauf des Jitters in Grad:

$$\varphi(t) = 2 \arcsin \left(\frac{A_\varphi}{2A}\right)$$

Mißt man die Jitterstörung $N_j$ sowie die Leistung des unverjitterten Taktes N, so erhält man:

$$\frac{N_J}{N} = \frac{\left(2 \cdot A \cdot \sin \frac{\varphi(t)}{2}\right)^2}{(A)^2} = 4 \sin^2 \frac{\varphi(t)}{2}$$

bzw.

$$\varphi(t)_{eff} = 2 \arcsin \sqrt{\frac{N_J}{4N}} \; ;$$

$\varphi(t)_{eff}$ ist dabei der Effektivwert des Jitters in Grad.

Mit der betrachteten Einrichtung zur Jittermessung wurden Messungen in einem Übertragungssystem für pulscodemodulierte Signale mit einer Bitrate von 565 Mbit/s durchgeführt. Bei diesen Messungen konnte bei der vergleichsweise hohen Bitrate noch ein Jitter von 1° sicher bestimmt werden. Dazu wurde mit dem Ausgang des Verstärkers ein Leistungsmesser verbunden, eine Untersuchung des Restsignals mit einem Oszillografen bzw. einem Spektrumanalyser konnte als ergänzende bzw. vorbereitende Grobmessung zu Hilfe genommen werden.

**Patentansprüche**

1. Verfahren zur Messung des Jitters von Taktsignalen in Übertragungssystemen hoher Bitrate unter Verwendung eines jitterfreien Referenzsignals, dadurch gekennzeichnet, daß aus dem jitterbehafteten Taktsignal und aus dem jitterfreien Referenzsignal jeweils ein sinusförmiges Signal mit einer Frequenz entsprechend der Taktfrequenz gebildet wird, daß beide sinusförmigen Signale mit gleicher Amplitude aber mit einer solchen relativen Phasenverschiebung überlagert werden, daß dadurch das Taktsignal bei Abwesenheit von Jitter unterdrückt würde und daß das vom Jitter bedingte verbleibende Restsignal bestimmt wird.

2. Verfahren nach Patentanspruch 1, dadurch gekennzeichnet, daß das verbleibende Restsignal zur Bestimmung des Jittermomentanwertes einem Oszillografen und zur exakten Bestimmung des Jittereffektivwertes einem Leistungsmesser zugeführt wird.

3. Anordnung zur Durchführung des Verfahrens nach einem der Ansprüche 1 oder 2 mit einem ersten Eingang (Rs) für das Referenzsignal und einem zweiten Eingang (Ts) für das jitterbehaftete Taktsignal, dadurch gekennzeichnet, daß mit dem ersten Eingang (Rs) der Eingang einer ersten Reihenschaltung aus einer Einrichtung (VZG) zur variablen Verzögerung, einem variablen Dämpfungsglied (VD) und einem ersten Tiefpaß (TP1) verbunden ist, dessen Ausgang mit dem ersten Eingang eines Richtkopplers (Rk) verbunden ist, daß mit dem zweiten Eingang (Ts) eine zweite Reihenschaltung aus einem zweiten Tiefpaß (TP2) und einem festen Dämpfungsglied (FD) verbunden ist, dessen Ausgang mit dem zweiten Eingang des Richtkopplers (Rk) verbunden ist, und daß der Ausgang des Richtkopplers über einen Verstärker (V) an eine Meßeinrichtung (ME) angeschlossen ist.

**Claims**

1. Method for measuring the jitter of timing signals in transmission systems of high bit rate employing a jitterfree reference signal, characterised in that a sinusoidal signal having a frequency corresponding to the timing frequency is respectively formed from the timing signal subject to jitter and from the jitter-free reference signal, that both sinusoidal signals are superimposed on one another with the same amplitude, but with such a relative phase shift that the timing signal would be suppressed thereby in the absence of the jitter, and that the remaining residual signal conditioned by the jitter is determined.

2. Method as claimed in claim 1, characterised in that in order to determine the instantaneous jitter value the remaining residual signal is fed to an oscillograph and in order to exactly determine the effective jitter value the remaining residual signal is fed to an output meter.

3. Arrangement for the implementation of the method as claimed in one of claims 1 or 2 comprising a first input (Rs) for the reference signal and a second input (Ts) for the timing signal subject to jitter, characterised in that the first input (Rs) is connected to the input of a first series connection composed of a device (VZG) for variable delay action, a variable attenuator (VD) and a first lowpass filter (TP1) whose output is connected to the first input of a directional coupler (Rk), that the second input (Ts) is connected to a second series connection composed of a second low-pass filter (TP2) and a fixed attenuator (FD) whose output is connected to the second input of the directional coupler (Rk), and that the output of the directional coupler is connected to a measuring device (ME) by means of an amplifier (V).

**Revendications**

1. Procédé pour mesurer l'instabilité de signaux d'horloge dans des systèmes de transmissions à débit binaire élevé, avec mise en oevre d'un signal de référence dépourvu d'instabilité, caractérisé par le fait que l'on forme, à partir du signal d'horloge affecté d'instabilité et à partir du signal de référence dépourvu d'instabilité, respectivement un signal de forme sinusoïdale d'une fréquence qui correspond à la fréquence d'horloge, que les deux signaux de forme sinusoïdale sont superposés entre eux avec la même amplitude mais avec un déphasage relatif tel que le signal d'horloge soit supprimé dans le cas de l'absence d'une instabilité et que le signal résiduel, dû à l'instabilité, est déterminé.

2. Procédé selon la revendication 1, caractérisé par le fait que le signal résiduel qui resre est appliqué à un oscillographe pour déterminer la valeur instantanée de l'instabilité et à un wattmètre pour déterminer de façon précise la valeur effective de l'instabilité.

3. Dispositif pour la mise en oeuvre du procédé selon l'une des revendications 1 ou 2, avec une première entrée (Rs) pour le signal de référence et une seconde (Ts) pour le signal d'horloge affecté d'instabilité, caractérisé par le fait qu'à la première entrée (Rs) est relié un premier circuit série, constitué par un dispositif (VZG) pour retard variable, par un élément d'atténuation variable (VD) et par un premier passe-bas (TP1), dont la sortie est reliée à la première entrée d'un coupleur directif (Rk), qu'à la seconde entrée (Ts) est relié un second circuit série, constitué par un second passe-bas (TP2) et par un élément d'atténuation fixe (FD), dont la sortie est reliée à la seconde entrée du coupleur directif (Rk), et que la sortie du coupleur directif (Rk) est reliée, par l'intermédiaire d'un amplificateur (V) à un dispositif de mesure (ME).

4

Rs

VZG  VD  TP1

Ts

TP2  FD

RK  V

ME